# EUROPEAN PATENT APPLICATION

(11) **EP 2 804 218 A1**
(43) Date of publication of application: **19.11.2014**
(21) Application number: 13167792.4
(22) Date of filing: 15.05.2013
(51) Int. Cl.: H01L 31/0224, H01L 31/18

(54) **Method for forming metal silicide layers**

(71) Applicant: Excico Group NV, 3500 Hasselt (BE)
(72) Inventor: Emeraud, Thierry, 3500 Hasselt (BE); Lerat, Jean-François, 3500 Hasselt (BE)
(74) Representative: BiiP cvba

(57) **Abstract**

The present invention is directed to a method for forming a metal silicide layer for a photovoltaic cell contact, the method comprising:
- a step of depositing a first metal layer on a silicon substrate surface,
- a step of performing a laser annealing step thereby forming metal silicide

characterized in that said steps are part of an in-line continuous process..

In addition, the present invention is directed to an apparatus for forming a metal silicide layer for a photovoltaic cell contact, the apparatus comprising:
- a first deposition station for providing a first metal layer on a silicon substrate surface,
- a laser annealing station for annealing thereby forming metal silicide
- a substrate transport means

characterized in that at least the first deposition station, the laser annealing station and the substrate transport means are adapted to integrated in-line continuous processing.

## Description

### FIELD OF THE INVENTION

The disclosed technology relates to a method of forming metal silicide layers, and more in particular, a method of forming patterned metal silicide layers in a metallization process for silicon photovoltaic cells.

### BACKGROUND

The current industrial standard processes for front side metallization of silicon photovoltaic cells are based on screen printing of silver pastes or inks that need to be fired for good contact formation.

In essence, screen-printing technology is very simple. A pattern is designed on a mesh screen and a suitable silver paste is applied through said screen to form the front contacts using a printing machine. The paste is then fired in a furnace.

But as wafers have become thinner and new technologies have evolved, screen printing shows a number of limitations. These include the increased resistance of silver due to additives in the paste, the challenge of achieving a sufficient aspect ratio of the metal lines (height over width), the difficulty in aligning metal patterns on wafers and the mechanical stress incurred to wafers during the process.

In an attempt to overcome the limitations of screen printing, photovoltaic cell manufacturers are currently developing two-step metallization processes on the front contacts wherein for example nickel and silver (Ni-Ag), or nickel, copper and tin (Ni-Cu-Sn), are deposited.

The first metal layer in the 2- step or 3-step metallization process - the seed layer - is made of a transition metal, such as Ni, and is deposited onto silicon by physical vapor deposition (PVD) or by plating in order to form a metal silicide upon annealing at a high temperature. The annealing step is typically done in an inert environment (e.g. N₂) by rapid thermal annealing (RTA) or in a belt firing furnace either after 1^{st} metal seed layer deposition or after the whole metal stack deposition. A high-conductivity metal such as Cu or Ag is then plated on top of this seed layer.

A benefit of this technique is that, while the silicide layer reduces metal-to-semiconductor contact resistance and improves mechanical adhesion, it also prevents the diffusion of Cu into the Si emitter, resulting in higher cell efficiency than the conventional screen-printing process.

However, since solar cell manufacturing should evolve towards manufacturing rates of several hundred or several thousands of wafers per hour per manufacturing unit in order to enter profitable mass production, a general constraint with respect to the above described 2-step metallization process is throughput and cost, in particular throughput and cost of the silicidation process.

In addition, another main problem consequently arising upon seeking improvement of solar cell efficiency is control of the metal silicide quality, in particular controlled formation of metal mono-silicide. Metal mono-silicide has beneficial contact resistance characteristics compared to other stoichiometries.

Another main problem of state-of-the art processes is metal silicide thickness uniformity and consequently improved contact resistance uniformity within cell and/or from cell to cell.

Combination of the above problems wherein insufficient control of metal silicide stoichiometric composition uniformity and insufficient control of metal silicide thickness uniformity intensify each other, results in low or significantly decreased performances.

An additional problem of state-of-the art processes is the high risk for junction damage due to nickel diffusion into the silicon during the RTA silicidation process, resulting in shunting of the (emitter) junction. Obviously, such nickel diffusion severely hinders the manufacturing of photovoltaic cells with shallow emitter structure. An additional problem of conventional methods is that, because in current metal plating industrial fabrication processes, the openings in the antireflection coating are typically formed by laser ablation, defects or damage to the silicon surface created by such laser ablation increase the risk of nickel diffusion during a subsequent RTA silicidation process and thus increase risk of (emitter) junction damage and (emitter) shunting.

Considering the above, it is a main object of the present invention to provide a method and apparatus enabling metal silicide formation at improved throughput and decreased manufacturing cost.

It is another main object of the present invention to provide a method and apparatus facilitating entering a 2-step metallization process into profitable photovoltaic cell mass production.

Another object of the present invention is to provide a method and apparatus enabling improved control of the metal silicide quality, in particular enabling controlled formation of metal mono-silicide.

Further, it is an object of the present invention to provide a method and apparatus enabling better control of metal silicide thickness uniformity and consequently improved contact resistance uniformity within cell and/or from cell to cell.

Another object of the present invention is to provide a method and apparatus enabling more accurate control of metal diffusion into silicon, thereby decreasing the risk for junction damage and shunting.

Another object of the present invention is to provide a method and apparatus enabling localized and controlled diffusion of metal into the silicon.

Another object of the present invention is to provide a method and apparatus enabling as an additional benefit the curing of defects generated by the previous laser ablation step.

Further, it is an object of the present invention to provide a method and apparatus wherein the extent of diffusion of metal is less dependent upon silicon defects and damages, but more upon thermal budget.

In addition, it is an object of the present invention to provide a method and apparatus enabling formation of a metal silicide with improved roughness characteristics.

Finally, it is a main object of the present invention to provide a method and apparatus for manufacturing photovoltaic cells with improved Fill Factor (FF), improved Pseudo Fill Factor (pFF), and improved overall performances compared to state of the art manufacturing methods.

In particular, it is an object of the present invention to provide a method and apparatus enabling the formation of a high quality mono nickel silicide layer compatible with thin emitters and/or thin junctions as required for the manufacturing of silicon solar cells at high throughput.

The above objects are met by providing an integrated in-line continuous method for forming a metal silicide layer for a photovoltaic cell contact and by providing an apparatus adapted for in-line continuous processing of a metal silicide layer for a photovoltaic cell contact.

### SHORT DESCRIPTION OF THE DRAWINGS

FIG 1 demonstrates the principle of in-line continuous processing in accordance with the present invention.
FIG 2, 3 and 4 illustrate embodiments of an apparatus in accordance with the present invention.

### SUMMARY OF THE INVENTION

The present invention is directed to a method for forming a metal silicide layer for a photovoltaic cell contact, the method comprising:
- a step of depositing a first metal layer on a silicon substrate surface,
- a step of performing a laser annealing step thereby forming metal silicide
**characterized in that** said steps are part of an in-line continuous process.

In addition, the present invention is directed to an apparatus for forming a metal silicide layer for a photovoltaic cell contact, the apparatus comprising:
- a first deposition station for providing a first metal layer on a silicon substrate surface,
- a laser annealing station for annealing thereby forming metal silicide
- a substrate transport means
**characterized in that** at least the first deposition station, the laser annealing station and the substrate transport means are adapted to integrated in-line continuous processing.

### DETAILED DESCRIPTION

As a first embodiment in accordance with the present invention, a method for forming a metal silicide layer for a photovoltaic cell contact is provided, the method comprising:
- a step of depositing a first metal layer on a silicon substrate surface,
- a step of performing a laser annealing step thereby forming metal silicide
**characterized in that** said steps are part of an in-line continuous process.

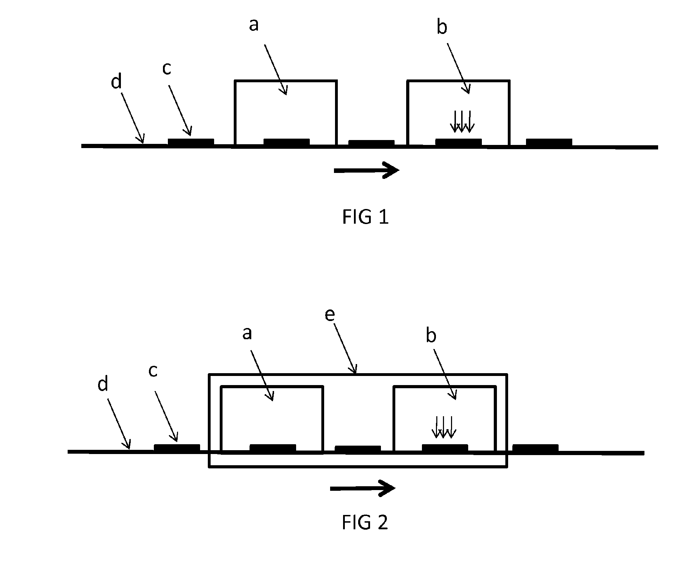

In the context of the present invention and as illustrated in FIG 1, in-line continuous processing is understood as processing wherein the silicon substrates (c) are processed while substantially continuously moving from a first process (a) to a second process (b) along a linear transfer path (d and arrow). Such in-line continuous process is in general intended for large-scale production, but may be obviously applied also for small-scale production.

Preferably, in a method in accordance with the present invention, the steps are part of an integrated in-line continuous process. In the context of the present invention, integrated is understood as the process steps involved being coordinated and structured such that they are considered representing one process sequence embedded in one apparatus.

Compared to any conventional method of silicide formation using a dedicated stand-alone apparatus like RTA or belt furnace equipment, by making laser annealing part of a (preferably but not necessarily integrated) in-line continuous process for formation of a metal silicide layer, throughput may be significantly improved and manufacturing cost decreased while obtaining more process robustness, more process stability, and at least comparable or better metal silicide quality.

Moreover, such method may be the key for implementing 2-step metallization into profitable photovoltaic cell mass production.

It is an advantage of the present invention to prevent oxidation effects by using a proper laser source, such that working in ambient air becomes possible, so that the state-of-the art requirement to work in an inert environment is thereby avoided and that implementing the inline-continuous process in a clean room facility becomes much easier.

It is an advantage of the present invention, e.g. when used for the formation of front side contacts of a photovoltaic cell, that the substrate is only heated at the front side, thus for example enabling the use of temperature-sensitive surface passivation layers such as amorphous silicon or AlOₓ at the rear side of the cell.

The silicon substrate may be for example crystalline silicon, undoped silicon or doped silicon, polycrystalline silicon, implanted silicon, or amorphous silicon, textured or non-textured silicon.

In an embodiment in accordance with the present invention, the laser annealing step is provided by a pulsed laser source, and may provide at least one laser pulse with a laser energy density in the range between 0.1 J/cm2 and 1.5 J/cm2 and with a laser pulse duration in the range between 1 ns and 10 ms, thereby converting at least part of the metal layer into a metal silicide layer.

In a particular embodiment in accordance with the present invention, an in-line continuous metal silicide formation process is provided wherein a metal layer deposition with thickness between 10-200 nm, particularly between about 20 nm and 100 nm, and preferably between about 20 nm and 50 nm, and subsequent annealing by pulsed laser with a laser energy density in the range between 0.1 J/cm2 and 1.5 J/cm2 and with a laser pulse duration in the range between 1 ns and 10 ms is provided. Such method may be more robust and stable compared to state-of-art methods, and enable better control of stoichiometric composition and composition uniformity of the metal silicide.

In an embodiment in accordance with the present invention, the metal is nickel and the metal silicide layer is a nickel silicide layer.

The laser source providing the at least one laser pulse may be any laser source whose wavelength, energy and pulse duration is adapted to the process, such as solid state lasers, diode lasers, fiber lasers or excimer lasers. Preferably, the laser source may be an excimer laser, more preferably a xenon chloride excimer laser.

The wavelength of the laser source may be in the range of 100 nm to 900 nm, 190 nm to 600 nm, 190 nm to 550 nm, or preferably 190 nm to 480 nm due to the high energy absorption of silicon at those wavelengths.

The irradiation energy may be in the range of 1 Joules to 25 Joules. In order to achieve these energies, the laser discharge volume is optimized to typically 10 cm (inter electrodes spacing) x 7 to 10 cm (discharge width) x 100 to 200 cm (discharge length).

In an embodiment in accordance with the present invention, the pulse duration may be in the range between about 1 ns and 10 ms, for example between about 1 ns and 1 ms, preferably between 1 ns and 250 ns,

In an embodiment in accordance with the present invention, a single laser pulse is used, with a pulse duration in the range between about 1 ns and 10 ms, for example between about 1 ns and 1 ms, particularly between about 1 ns and 250 ns.

Without being bound by any theory, using one pulse excimer laser annealing at appropriate energy density value with appropriate pulse length may generate a melt of silicon substrate under a metal layer, and create a metal silicide in the melted region only thus preventing silicon surface oxidation by ambient air.

In an embodiment in accordance with the present invention, providing the first metal layer can be done by any suitable method known to a person skilled in the art, such as for example PVD, sputtering, electroless plating, electroplating, light induced electroless plating (LIEP), or even more preferably light induced plating (LIP). Preferably a selective plating process, such as LIP, is used.

In an embodiment in accordance with the present invention, the laser energy density is between 0.1 J/cm2 and 1.5 J/cm2, preferably between 0.3 J/cm2 and 1.0 J/cm2, even more preferably between 0.3 J/cm2 and 0.7 J/cm2.

Preferably a single laser pulse is used having a relatively large beam spot size, e.g. substantially larger than a width of the openings in the dielectric layer, thereby avoiding the need for alignment of the laser beam to the openings. A step-and-scan approach can be used for irradiating the whole substrate surface, or at least at the solar cell contact locations. Preferably the beam spot size matches or is slightly larger than the whole substrate surface.

The laser beam spot form may be rectangular. Its length may be equal to the one of the solar cells or slightly superior or inferior, e.g. 125 mm, 156 mm or even 200 mm or greater, and its width may be in the range between about 0.1 and 50 mm. Using narrow elongated rectangular shapes resulting in a line beam, the laser irradiation may comprise scanning the substrate surface in the perpendicular direction to such line beam, which makes the present invention suitable for industrial manufacturing at high throughputs.

The laser beam may also irradiate the surface with 2D specific patterns (as described in WO2011104197), said pattern being replicated over the whole substrate area by moving the substrate surface exposed to the laser beam at appropriate speed.

In a particular embodiment in accordance with the present invention, with each pulse a portion of at least 1 cm², at least 5 cm², at least 10 cm², or at least 100 cm² may be irradiated, which makes the present invention suitable for industrial manufacturing of photovoltaic cells at high throughputs.

In an embodiment in accordance with the present invention, forming openings through the dielectric layer can for example be done by laser ablation, also being part of the inline-continuous process. However, the present disclosure is not limited thereto and other suitable methods can be used. For example, forming openings through the dielectric layer can comprise providing a patterned masking layer (such as by ink jet printing) followed by wet etching of the dielectric layer.

If laser ablation is used, an advantage of the present invention is that the risk of emitter junction shunting is avoided or substantially reduced as compared to prior art methods, because of the laser annealing used in the in-line continuous process. In addition, also surface damage due to laser ablation may be cured.

After performing the laser annealing step, an etch step may be part of the in-line continuous process for removing unreacted metal in case the deposition of the first metal layer was not selective. The etch step can for example comprise etching in a wet etching solution comprising HNO₃, H₂O₂:H2SO₄ or HCl:HNO₃ or any other suitable etching solution known by a person skilled in the art. This etch step may be followed by a second plating step, preferably light induced plating thereby e.g. forming a Ni/Cu stack or a Ni/Cu/Ag stack or a Ni/Cu/Sn stack or any other suitable stack known to a person skilled in the art on top of the metal silicide layer.

In a preferred embodiment according to the present invention, the deposition step of the first metal layer is a selective plating step, followed by pulsed laser annealing and a second plating step being part of the in-line continuous process, making complete contact stack formation an in-line continuous process being key to profitable photovoltaic cell mass production.

In addition, in an embodiment in accordance with the present invention and as illustrated in FIG 2, 3 and 4, an apparatus (e) for forming a metal silicide layer for a photovoltaic cell contact is provided, the apparatus comprising:
- a first deposition station (a) for providing a first metal layer on a silicon substrate surface (c),
- a laser annealing station (b) for annealing thereby forming metal silicide
- a substrate transport means (d),
**characterized in that** at least the first deposition station (a), the laser annealing station (b) and the substrate transport means (d) are adapted to integrated in-line continuous processing (arrow).

Adapted to integrated in-line continuous processing is understood as adapted such that the different stations are embedded in one apparatus and considered representing one in-line continuous metal silicide formation station.

By making laser annealing equipment adapted to integrated in-line continuous processing such that it can be implemented in an apparatus for integrated in-line continuous formation of a metal silicide layer, throughput may be significantly improved and manufacturing cost decreased while obtaining more process robustness, more process stability, and at least comparable or better metal silicide quality.

Moreover, such apparatus may be the key for implementing 2-step metallization into profitable photovoltaic cell mass production.

It is also an advantage as explained above that laser annealing in ambient air becomes possible and that implementing the apparatus in a clean room facility becomes much easier.

In an embodiment, the first deposition station, the laser annealing station and the substrate transport means may be adapted such that the integrated in-line continuous processing is restricted to single-axis displacement between the stations, preferably limited to single-axis displacement in horizontal direction. However, vertical direction by means of a corresponding conveyor system is also possible.

In accordance with the present invention, the substrate transport means may comprise a conveying system such as a belt conveyer, a gripping conveyer, a roller conveyer etc.

In accordance with the present invention, the apparatus may constitute a plurality of lanes for increasing wafer processing speed. This speed may be up to 1000 wafers per hour, up to 2000, up to 3000, up to 4200 or even up to 7200 wafers per hour.

In a particular embodiment, the repetition rate of the laser may be geared to the conveying system speed to enhance throughput. The speed may be up to 2 meters per min, or even up to 4 meters per min.

In an embodiment in accordance with the present invention, the laser annealing station comprises a beam shaping system. Preferably, the beam shaping system may be adapted for adjusting the beam spot size matching the photovoltaic cell width.

The laser annealing station may provide one or several laser annealing beams, each beam matching the photovoltaic cell width. In case of one single laser annealing beam, substrates leaving the first deposition station including one or several lanes, are fed in the laser annealing lane. In case of several laser annealing beams, substrates leaving the first deposition station lanes may be fed directly towards the corresponding laser beam.

Preferably, the first deposition station is a PVD station or a first plating station, most preferably a selective plating station, such as for example a LIP or LIEP station.

In an embodiment, the apparatus may also comprise a (second) plating station following the laser annealing station and being adapted to integrated in-line continuous processing, such that the apparatus enables formation of complete photovoltaic cell contact stacks.

Further, the apparatus may additionally comprise a laser ablation station adapted to the integrated in-line continuous processing sequence.

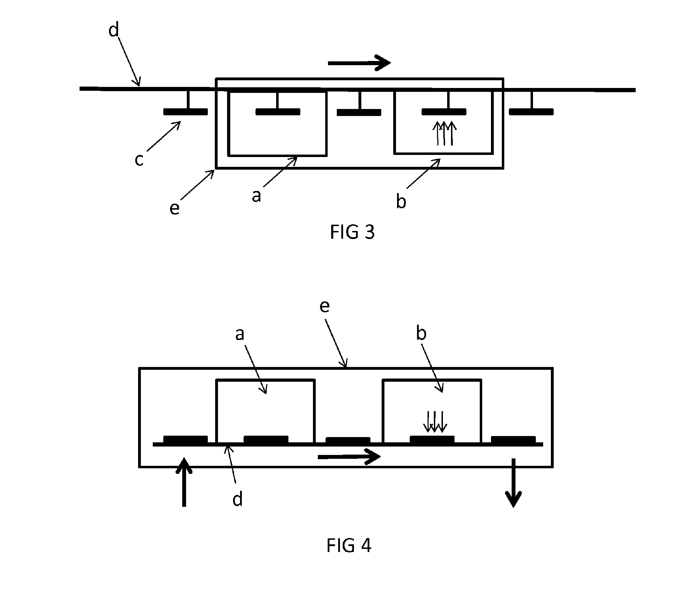

The apparatus in accordance with the present invention may be configured with or without substrate carriers, and with processing the substrates on top side (see FIG 2) or on bottom side (see FIG 3).

In case of vertical displacement, substrates or carriers may be transported at a small angle from vertical direction to allow use of gravity to hold the substrates in place and to orient the substrates in a better condition for improved debris management.

The apparatus may be configured as a straight in-line tool with substrates present on the substrate transport means entering and leaving the apparatus at opposite sides (see FIG 2 and 3), or less preferably it can be configured with substrate transversal loading on and unloading from the substrate transport means (see FIG 4). In the latter case the apparatus can still be introduced into overall in-line processing and processing within the apparatus still corresponds to the principle of in-line continuous processing but additional (un-)loading mechanisms may be required before and after metal silicide formation.

Pre and post silicidation treatments, heating and/or cooling and/or drying and/or cleaning steps or stations can be incorporated.

As understood by person skilled in the art, a method and apparatus in accordance with the present invention may be used for providing contacts to the front side of a photovoltaic cell and can also be used for providing contacts to the rear side of a photovoltaic cell.

The method and apparatus can be used in a fabrication process for different types of photovoltaic cells, such as back contact back junction cells (e.g. lnterdigitated back contact cells), Metal Wrap Through cells, Emitter Wrap Through cells, and bifacial cells.

## Claims

1. A method for forming a metal silicide layer for a photovoltaic cell contact, the method comprising:
- a step of depositing a first metal layer on a silicon substrate surface,
- a step of performing a laser annealing step thereby forming metal silicide
**characterized in that** said steps are part of an in-line continuous process.

2. A method according to claim 1, wherein between said steps the silicon substrate is exposed to single-axis displacement.

3. A method according to claim 1 or 2, wherein the silicon substrate is transported via a conveying system.

4. A method according to claims 1 to 3, wherein performing a laser annealing step comprises providing at least one UV laser pulse with a laser fluence in the range between 0.1 J/cm2 and 1.5 J/cm2 and with a laser pulse duration in the range between 1 ns and 10 ms, thereby converting at least part of the first metal layer into a metal silicide layer.

5. A method according to claim 1 to 4, wherein the laser annealing is performed in ambient air.

6. A method according to claims 4 to 5, wherein the UV laser pulse is provided by an excimer laser.

7. A method according to claims 1 to 6, wherein the first metal layer is provided by plating or PVD.

8. An apparatus for forming a metal silicide layer for a photovoltaic cell contact, the apparatus comprising:
- a first deposition station for providing a first metal layer on a silicon substrate surface,
- a laser annealing station for annealing thereby forming metal silicide
- a substrate transport means
**characterized in that** at least the first deposition station, the laser annealing station and the substrate transport means are adapted to integrated in-line continuous processing.

9. An apparatus according to claim 8, wherein the substrate transport means exposes the silicon substrate to single-axis displacement between the stations.

10. An apparatus according to claims 8 to 9, wherein the substrate transport
means comprises a conveying system.

11. An apparatus according to claims 8 to 10, wherein laser annealing station is
open to ambient air.

12. An apparatus according to claims 8 to 11, wherein the laser annealing station
comprises a beam shaping system adapted for adjusting the beam spot size matching the photovoltaic cell width.

13. An apparatus according to claims 8 to 12, wherein the first deposition station is
a PVD station or a first plating station.

14. An apparatus according to claims 8 to 13, comprising a second plating station
being adapted to integrated in-line continuous processing.
